Europäisches Patentamt

European Patent Office

Office européen des brevets

(19)

(11) Publication number: **0 388 077 A2**

# EUROPEAN PATENT APPLICATION

(12)

(21) Application number: 90302451.1

(22) Date of filing: **07.03.90**

(51) Int. Cl.5: **G06F 9/45**

(30) Priority: **15.03.89 US 324273**

(43) Date of publication of application:
**19.09.90 Bulletin 90/38**

(84) Designated Contracting States:
**DE FR GB IT NL**

(71) Applicant: **TEXAS INSTRUMENTS
INCORPORATED
13500 North Central Expressway
Dallas Texas 75265(US)**

(72) Inventor: **Keenan, W. Russ
10208 Panther Ridge
Dallas, Texas 75243(US)**
Inventor: **Comen, Stephen F.
3708 Parkmont Drive
Plano, Texas 75023(US)**
Inventor: **Brainard, Robert J.
4220 Mulberry Drive
Carrollton, Texas 75007(US)**

(74) Representative: **Abbott, David John et al
Abel & Imray Northumberland House 303-306
High Holborn
London, WC1V 7LH(GB)**

(54) Method of optimizing the execution speed of an interpreted test language.

(57) Disclosed is a method which speeds up interpretive test program code execution and allows rapid changes to the test code.

Figure 1

a. Compiled language    b. Interpreted language

# METHOD OF OPTIMIZING THE EXECUTION SPEED OF AN INTERPRETED TEST LANGUAGE

This application is a continuation-in-part of U.S. Patent Application Serial No. 183,195, filed April 19, 1988.

## FIELD OF THE INVENTION

This invention relates to test systems for semiconductor devices, and more particularly to a method of executing interpreted language test programs at speeds comparable to or faster than a compiled language.

## BACKGROUND OF THE INVENTION

Most integrated circuit testers are required to fulfill two functions: First, they are used in a production environment to test large numbers of devices. Second, they are used for engineering purposes, such as test program development and device characterization.

These two environments have very different requirements for test programming languages. In a production environment, the overriding concerns are tester accuracy and the execution speed of device test programs. In an engineering environment, the concerns include the speed of the test program development/debug cycle, test program flexibility, and the availability of tools for device characterization, program development, and other engineering functions.

These widely differing requirements must be fulfilled by a single test language. In general, there are two ways in which languages can be implemented: compiled or interpreted.

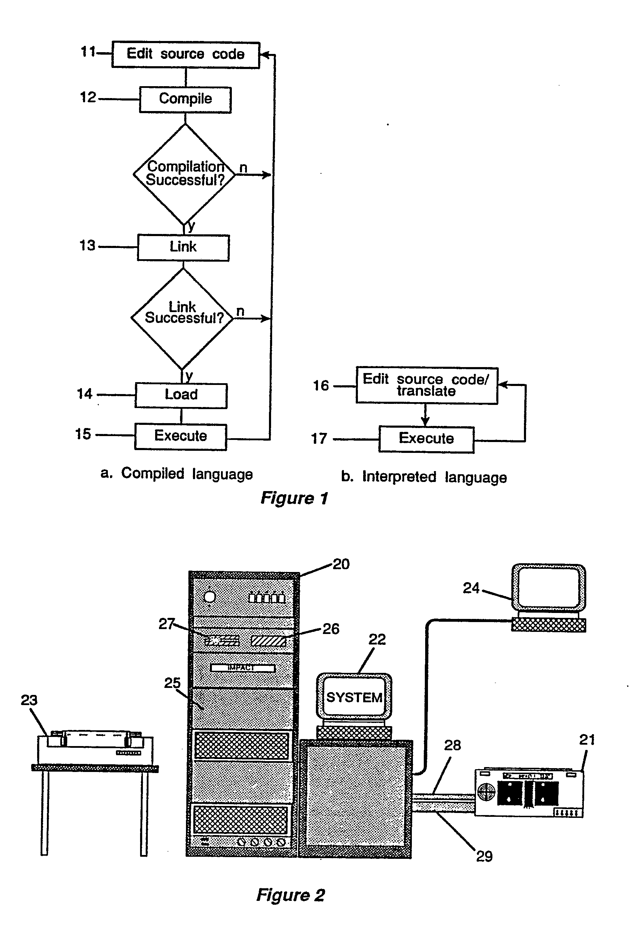

When a program is compiled, Figure 1a, the statements in the program are translated into object code. This object code is then linked with the necessary runtime routines to form a set of machine code instructions. Compiled programs tend to execute very fast since each program is compiled into low level machine code. These machine code instructions are then loaded into the controller memory and executed. However, in order to make changes to a program, the source code must be edited (11), recompiled (12), relinked (13), and reloaded (14) before it can be executed again (15). This can take anywhere from tens of seconds to hours, depending on the length of the program, the speed of the compiler, and the system on which the program is being compiled. In addition, the use of many engineering tools tied heavily to the programming language often requires recompilation of the program, making the use of many engineering functions a very lengthy process.

An interpreter, Figure 1b, on the other hand, does not generate machine code for each statement. Instead, an interpreter executes a program by examining the source code or a modified form of the source code for each statement and calling appropriate subroutines to perform the actions specified by the source code statements. Because there is no compilation or linking required, making a change to an interpreted program only takes the amount of time required to edit the source code (16). The program can then be reexecuted (17) immediately. Also, there is usually little or no time required to enable engineering tools which are tied to the language, such as a statement tracer. Unfortunately, the same structure that makes an interpreted language very flexible also means that interpreted programs generally execute much slower than compiled programs.

In designing a test language, it is necessary to choose between a compiled or an interpreted language. A compiled language is obviously well suited for a production environment because of its superior execution speed, while an interpreted language is ideally suited to an engineering environment because of its flexibility and fast program development/debug cycle.

Most vendors of test equipment have chosen to use a compiled language to suit the needs of the production environment. Some vendors have then used techniques such as incremental compilation in an attempt to adapt the compiled language for use in an engineering environment.

An incremental compiler can compile some certain types of instructions interactively, without requiring a long compilation and link phase. However, an incremental compiler still does not have the flexibility afforded by an interpreted language, especially for implementing various useful engineering tools.

The truly desirable language is one which provides the execution speed attainable by a compiled language but provides all of the flexibility and engineering advantages of an interpreted language.

## BRIEF DESCRIPTION OF THE INVENTION

The invention described herein relates to a method of allowing an interpreted language to execute at speeds comparable to or faster than those achievable by a compiled language, while still retaining all of the flexibility inherent in an interpreted language. It is based on several assumptions which hold true in integrated circuit device testers and the specific device test programs executed by these machines.

First, in a production environment where large numbers of devices are being tested, the test program consists of a main loop which is executed multiple times, usually once for each device.

Second, a large number of the statements within the device test program use constant values which do not change as the main program loop is being executed, or use only a small number of values, all of which can be determined the first time a statement is executed.

The method of the invention, known as 'turbo', is to change the normal operation of an interpreter so that the first time a statement of the above type is executed, a table is built which contains information which can be used to bypass much of the original processing the next time the statement is executed. The simplest form of turbo builds a table which contains the address of each write performed by a statement, along with the value written to that address. The internal representation of the interpreted code is then modified so that the next time the statement is executed, the only processing which occurs is to write the table of values to their corresponding addresses.

More complicated forms of turbo involve storing the addresses of selected variables in a table to allow direct access to these variables in controlled situations. The interpreted code can then bypass much of the normal processing required for these types of statements. These methods will be described in detail in the following description of a preferred embodiment.

The statements which have been modified according to the method of the invention herein described, known as 'turboed' statements, execute significantly faster than the same statements would execute in a normal compiled environment.

When a large percentage of the statements in a device test program are turboed, the high speed of these statements can offset the slower execution speed of the non-turboed statements, resulting in overall execution time which is comparable to or faster than that achieved by compiled languages. The fact that the first execution of the test program executes relatively slowly while all of the turbo structures are being set up is insignificant in a production environment where a large number of devices are being tested.

## BRIEF DESCRIPTION OF THE DRAWINGS

Figures 1a and 1b show the typical debug/development cycle of a compiled language versus an interpreted language;

Figure 2 is a drawing of a typical computer-tester according to the present invention;

Figure 3 is a block diagram of the tester of Figure 2.;.

Figure 4 shows the translated structure of a typical TPL statement;

Figure 5 is a flow chart of the interpreter main control loop;

Figure 6 is a flow chart of the VCC processing routine;

Figure 7 is a flow chart of the set_icc routine;

Figure 8 is a flow chart of the VCC processing with turbo added;

Figure 9 shows the translated structure of a typical TPL statement after it has been turboed;

Figure 10 is a flow chart of the simple case turbo routine;

Figure 11 shows the structure of a loop turbo table;

Figure 12 is a flow chart of the loop turbo routine;

Figure 13 shows the syntax of IF verbs which can be turboed;

Figure 14 shows the structure of an IF verb turbo table; and

Figure 15 is a flow chart of the IF turbo routine.

## DETAILED DESCRIPTION OF A PREFERRED EMBODIMENT

Turbo has been implemented on several integrated circuit testers manufactured by Texas Instruments, Inc. All of these testers use a VMEbus controller and execute an interpreted language called TPL, or Test Program Language.

Turbo has been implemented on an SSI/MSI logic tester and on several memory testers. Turbo is in no way restricted to use only on these machines. It has been used most extensively on the SSI/MSI logic tester, since test time on a logic tester is more dependent upon the software execution speed than test time on a memory tester. Therefore turbo is most beneficial on a logic tester.

The tester (Figure 2) consists of a main chassis (20), one to four independent test heads (21), a system control monitor (22), line printer (23), and a test head monitor (24) for each test head.

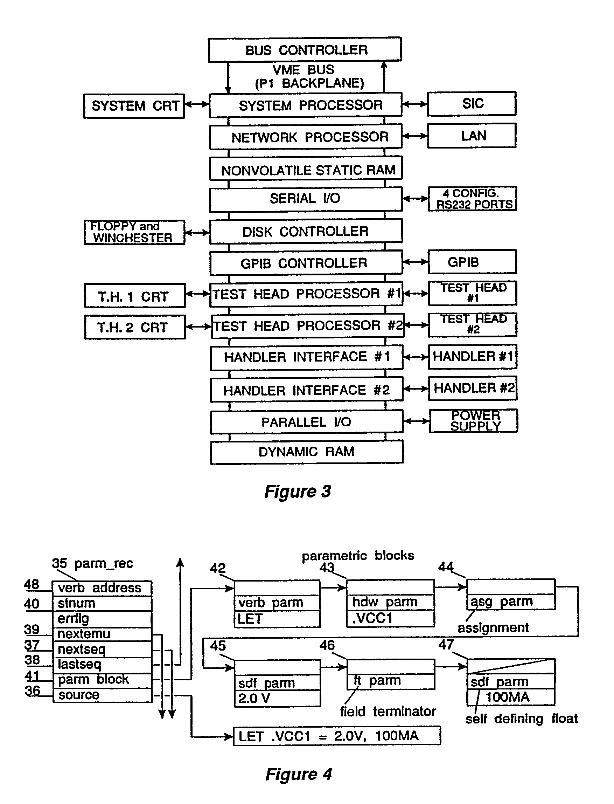

The main chassis contains power supplies, a VMEbus controller (25), Winchester disk (26), a floppy disk drive (27), auxiliary ports, local area network connections, and other necessary peripherals. A block diagram of the VMEbus controller is shown in Figure 3. The test heads are connected to the main chassis by power supply cables (28) and a sixteen bit parallel I/O cable (29). Each test head is controlled by a processor board based on the Motorola 68020 microprocessor. This processor board runs a single program which constitutes an editor, loader, and interpreter for the TPL language.

An important aspect of the tester hardware is that the test head hardware is memory mapped into the address space of the 68020 test head processor. This allows access to the test head hardware to be treated the same as access to normal processor memory. This factor is critical to the operation of the invention, as will be shown below.

TPL is a language which is similar to the BASIC programming language, but contains many extensions that are useful in a device test environment. A different version of TPL exists for each type of tester. Each version contains extensions which are specific for the hardware present on the tester being used.

Each TPL instruction starts with a verb and is followed by specific variable names or parameters as allowed by the syntax of each verb. A simple example is the statement
LET .VCC1 = 2.0V,100mA
which will program the VCC1 (power supply) board contained in the tester test head to 2.0V with a current of 100mA and will save the values 2.0V and 100mA in a specific memory location so they can be recalled later if necessary.

The verb in the statement above is LET. The first parameter to the LET verb is .VCC1, which signifies that the VCC1 board on the test head is being programmed. This is followed the '=' sign, which is an assignment parameter. This separates the parameter being assigned from the parameters which are assigned. The assignment parameter is followed by a self-defining floating point value, 2.0V. This is followed by a field terminator ',' which is followed by another self-defining floating point value, 100mA.

As each statement is loaded into memory, it is translated into a structure as shown in Figure 4. Each statement is allocated a parm_rec structure (35).

This structure contains a pointer to the source code for the statement (36), pointers to the next statement (37), previous statement (38), and next executable statement (39), various other flags and variables (40), and a pointer to the parameter blocks (41) for the statement. The first parameter block (42) contains the verb for the statement. This is followed by a parameter block for each parameter in the statement. In the example statement given above, these parameters are a hardware parameter .VCC (43), an assignment parameter '=' (44), a self-defining floating point parameter 2.0V (45), a field terminator parameter ',' (46), and a self-defining floating point parameter 100mA (47).

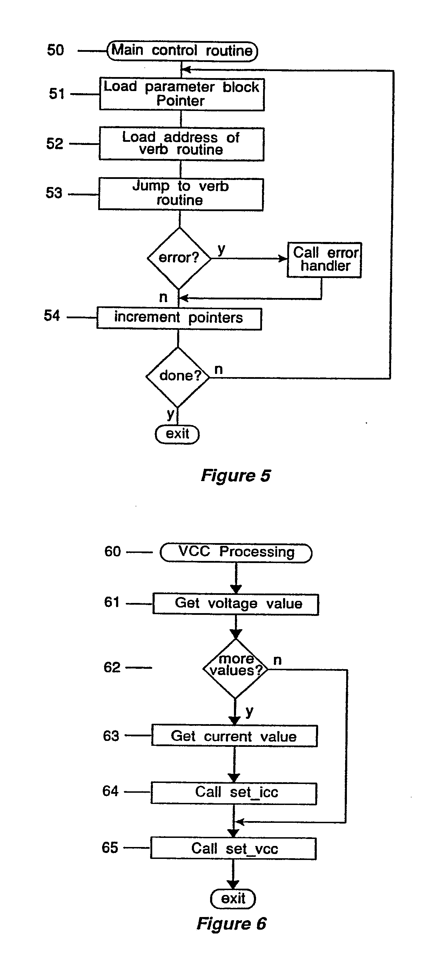

Execution of a device test program, Figure 5, is accomplished by entering a main loop of the interpreter (50). The parm_rec (35) for each statement contains a pointer to the verb routine used to interpret the verb specified by the statement (48). The main loop will set up several pointers (51) and then jump to the verb processing routine (52).

When control returns to the main line loop, it will check for any errors which may have occurred during verb execution (53). If no errors have occurred, it will increment necessary pointers to point to the next executable statement (54) and will branch back to the top of the loop. This continues until either there are no more executable statements or a fatal error occurs. Execution of the statement
LET .VCC1 = 2.0V,100MA
proceeds as follows:
First, the main loop of the interpreter loads the address of the statement into the appropriate pointer locations and then transfers control to the verb routine pointed to by the parm_rec structure for the line to be executed, in this case the LET verb processing routine.

The LET verb processing routine checks the next parameter, .VCC1, and determines that it is a hardware parameter. It then calls the hardware processing routine. This routine in turn calls the specific VCC processing routine, which executes as shown in Figure 6.

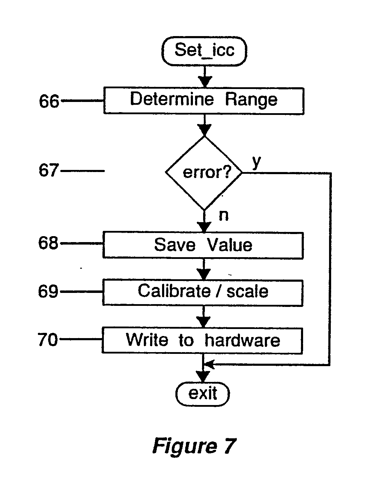

The VCC processing routine calls a routine to fetch the first parameter to be programmed, which is 2.0V (61). The VCC processing routine then checks to see if there are any more parameters for the statement (62). In this case, the currant value is also being programmed, so a routine is called which returns the next parameter, which is 100mA. (63). An internal subroutine set_icc is then called (64). The set_icc routine, Figure 7, checks the current value to verify it has a type of amps and determines which range it corresponds to among the possible values that can be programmed on the VCC1 board (66). If the value is not within a valid range, an error flag is set and the routine is exited (67). Otherwise, the value being programmed, 100mA, and the range number corresponding to this value are saved in a memory location where they can be accessed later if necessary (68). Before the value can be written to the hardware, it must be calibrated to correct any inaccuracies present in the hardware. This is done using a calibration algorithm such as
programmed value = desired value * gain + offset
where the gain and offset are predetermined values that depend on the range of the current being programmed (69).

The calibrated value must then be scaled to a sixteen bit value which is written to a specific address on the VCC1 board. The range number is written to another specific address on the VCC1 board (70). Together, these two values set the VCC1 board to drive the specified current of 100mA.

When control returns to the VCC processing routine from the set_icc routine, the routine set_vcc is called to program the voltage level on the VCC1 board (65) . The set_vcc routine functions in the same manner as the set_icc routine. It determines the proper range of the voltage being programmed, saves the value, calibrates and scales it, and writes the appropriate values to the VCC1 board. The VCC processing routine then returns control to the main interpreter loop and the next statement is executed.

In contrast, a typical compiler would treat the above statement as follows. When the statement is compiled, the compiler determines that the statement is programming the VCC1 board. It can check the values 2.0V and 100mA to be sure they are of the proper type and in the proper ranges and can determine the addresses to which the values should be written. However, the calibration values are not known at the time the statement is compiled. Therefore, the compiler will generate the machine language instructions to save 2.0V and 100mA for later reference. It will also generate the instructions to calibrate 2.0V and 100mA, then convert these values to the correct sixteen bit pattern and write them to the correct hardware addresses. These instructions generated by the compiler are placed sequentially with the instructions generated by the other statements in the program. When the program is executed, these instructions are executed in order by the processor. This code will obviously execute much faster than the code described above for the interpreted language TPL.

When turbo is used during the execution of a device test program, the interpreted code described above is modified in a manner which enables it to execute much faster than the code generated by a normal compiler. Turbo may be enabled or disabled as desired within a device test program by executing the statement
LET TURBO = .ON or
LET .TURBO = .OFF

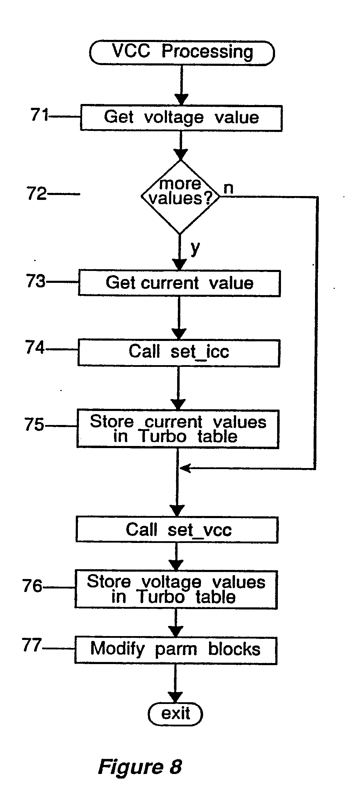

When turbo is enabled, the execution of the interpreter is altered as follows:
The first time the statement in the above example is executed, the interpreter works as described above, but some extra steps are followed in the VCC processing routine of Figure 6, and are shown in Figure 8.

First, the routine keeps track of whether or not the parameters being programmed are constants. Because the calibration values are not changed while a device test program is executing, if these parameters are constants, then all of the values computed and written by this statement will be the same every time the statement is executed. Therefore, after each parameter is processed and the correct values are saved in memory and written to the hardware, these values are stored into a turbo table (75,76), Figure 8. This table contains every value written, along with the address to which it is written, and also contains a field which tells the number of values which are in the table. Because the test head hardware is memory mapped into the address space of the processor, no distinction needs to be made between the values which are being saved in memory and those which are being written to the test head.

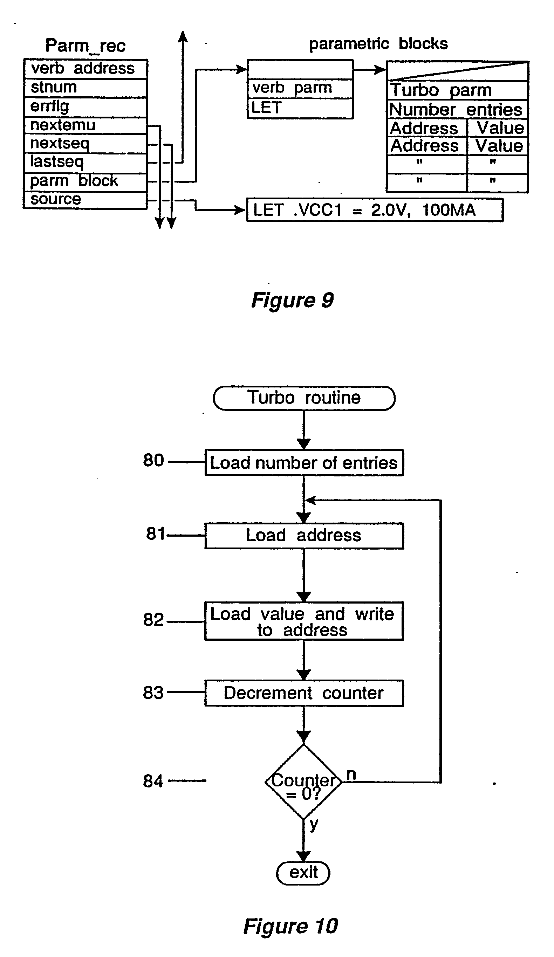

Once the turbo table has been built, the original parm_rec (35) (Figure 4) for the statement is modified so that the verb address (48) points to a special turbo routine instead of the LET verb processing. The second parameter block (43) is modified to point to the turbo table which was built (77) . This new structure is shown in Figure 9.

The next time this statement is executed, the interpreter main loop passes control to the turbo routine, Figure 10, instead of the LET verb processing routine. This routine uses the turbo table that was built the first time the statement was executed. It first loads the number of values that are stored in the table (80). It then enters a loop in which it loads the address to which each value is to be written (81), writes the specified value to that address (82), and decrements the count of values it loaded (83). The loop continues until each value has been written (84). Thus the entire statement execution is reduced to a simple loop which can execute much faster than normal interpreted or compiled code.

This is the simplest form of turbo. A similar form is used for statements of the type
LET .VTH(IN:PINS) = 1.0V
This statement programs the threshold voltage on of all the pin boards specified in the array IN:PINS to 1.0V. The processing for this statement works much like the processing for the statement above which programmed the VCC1 board, except that it makes an extra call to a routine which returns the list of pin boards specified in the IN:PINS array, and writes the appropriate values to all of these pin boards, instead of just programming a single board as was done with the .VCC1 board. The turbo table which is built for this statement has the same structure as the one built above, but it contains values and addresses to be written to multiple boards instead of a single board. It uses the turbo routine shown in Figure 10 for all subsequent executions of the statement.

The pin list which is specified in the above statement by the array IN:PINS demonstrates just one of the allowable syntaxes for specifying the pin list. It may also be specified as a list of constants, such as (1,2,3), an inclusive series of constants, such as (1. .4), or any combination of constants and/or arrays. In any case, where the pin list specification will remain constant for all executions of the instruction, the instruction can be turboed.

For this and all other types of turboed statements which allow the use of any array, a restriction is placed upon the test program that all elements of the array must be initialized before a turboable statement containing the array is executed the first time and the contents of the array cannot be changed between executions of a turboed statement.

However, in almost all cases any array which is used in a turboed statement contains a list of pins on the device being tested. These arrays are initialized at the beginning of the test program and will not be changed. These restrictions are necessary to allow the interpreter code to generate a turbo table which contains the proper address/value pairs for all possible elements of the array during the first execution of the instruction.

A slightly more complicated turbo table and turbo execution routine, known as loop turbo, is used for statements of the form
LET .VTH(IN:PINS(I)) = 1.0V
which programs the threshold level on a single pin board selected from the array IN:PINS.

In this case, a single element is being selected out of an array. However, as specified above, the size of the array and the contents of each element in the array are known the first time the statement is executed. Therefore, when the turbo table is built, it includes the data which will be written for each possible value of the array subscript, as well as the address in memory where the array subscript variable is stored.

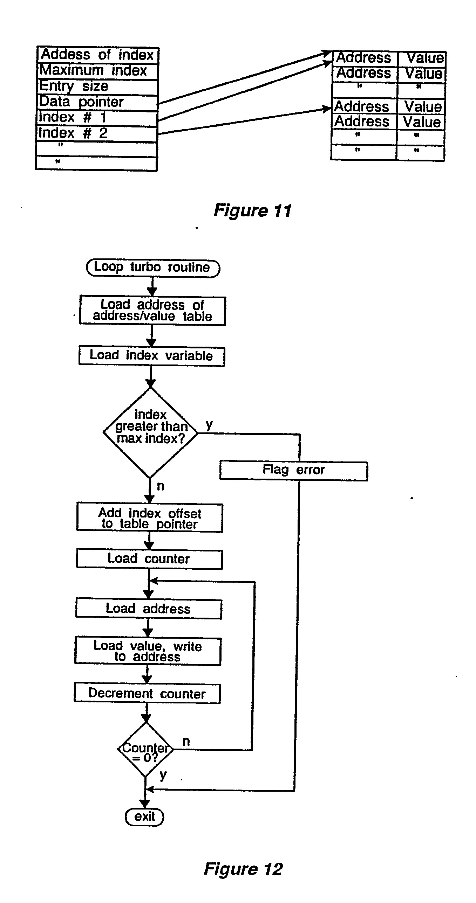

In addition, a second table is built. This table contains the address of the variable used to index into the array, the maximum array index allowed, the number of entries in the table, and a pointer to the table of address/value pairs. In addition, it contains an offset value for each possible value of the array subscript. This offset value points to the location in the address/value table corresponding to each array index value. The structure of this table is shown in Figure 11.

Once these two tables have been built, the parameter block structure is changed to point to the table described above.

In addition, the verb pointer for the statement is set to point to a loop turbo routine, which is called in place of the normal routine. Whenever this statement is executed again, this loop turbo routine reads the value of the array subscript, checks to ensure that it is within the array dimensions, and then loads the offset for the array subscript. This offset is used as an index into the turbo table to write the proper values to the selected hardware and memory locations. Figure 12 shows a flow chart of this routine.

The concept of storing a table of address/value pairs can also be applied to several TPL verbs besides LET. These include ENABLE, DISABLE, CONVERT, and some forms of the TMU verb. For each of these verbs, all of the values written and their corresponding addresses can be saved in a table on the first execution and all subsequent executions can simply output the values in the table to their correct addresses. The syntax of these verbs is shown in appendix A.

This technique is applicable when some of the test head hardware is being programmed, but cannot generally be used for taking readings from hardware. However, part of the processing for the TPL function .ADC, which is used to take readings from an analog-to-digital converter on the test head, can be turboed much as described above. For example, the statement
LET reading = .ADC( .VCC1( .ICC1,.AGND))
reads the current on the VCC1 board with respect to ground. The normal processing for this statement starts with the LET verb and eventually calls the ADC processing routine. This routine determines from which board the reading is being taken, (.VCC1), and the channels on which to take the reading (.ICC1, .AGND). This information is then written to the hardware along with a strobe to start the ADC reading. The ADC processing routine waits for the reading to complete, reads the value, calibrates it, and returns it to the let processing routine to be assigned to the specified variable.

All of the signals written to the test head when executing this statement are the same each time the statement is executed. Therefore, a turbo table can be built to hold these values and their addresses. The first time the statement is executed, this table is built by the ADC processing routine.

At the same time, the ADC processing routine modifies the parameter block structure for the statement so that the next time the statement is executed, a different path is followed.

Rather than calling the ADC processing routine, the LET verb processing routine now calls a turbo ADC processing routine. This routine writes the values in the turbo table to their proper addresses, which starts the ADC reading on the test head. The turbo routine then branches into the ADC processing routine at the point where the reading is actually made, and processing continues from there as normal.

It would be desirable to use these same type of constructions when variables are being used to program the hardware functions rather than constants. However, the first time a statement is executed which uses a variable to program the hardware, it is generally not possible to determine all of the possible values which can be assigned to the variable, and therefore no reasonable turbo table can be built. It would be possible to store the address of the variable in the turbo table, but the value would still need to be calibrated and scaled before it could be written to the hardware, negating much of the gain inherent in the turbo method.

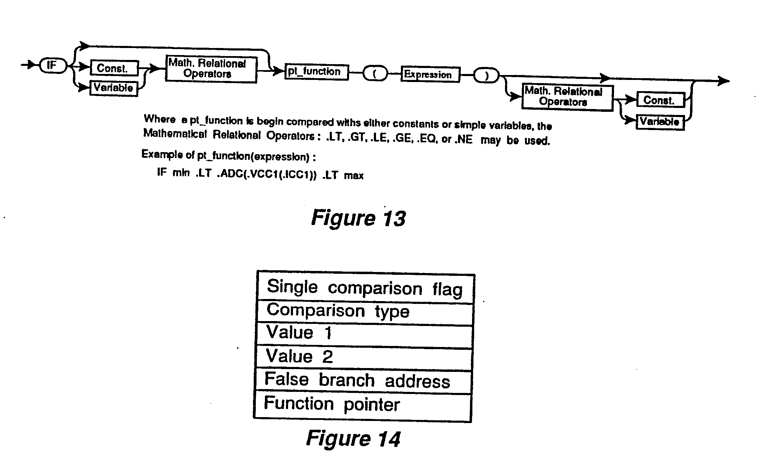

In certain cases, it is possible to use the address of a variable in a turbo table, as is done in the case above with subscripted arrays. Another application of this is in certain variations of the IF verb, as shown in Figure 13.

This is a common form of the IF verb which is often used to compare readings taken from the hardware. Usually, a hardware function such as .ADC is compared with a single limit or checked to see if it is between two limits. The first time an IF statement is executed, it is checked to see if it is of this form. If not, a flag is set in the parm_rec so the check will not be performed on subsequent executions. If the statement is of this form, it will be turboed. This is accomplished by building a turbo table as shown in Figure 14.

The turbo table built for an IF statement contains a flag to tell if there are one or two comparisons being performed, the type of comparison being performed, for example, (.LT (less than), .GT (greater than), .LE (less than or equal), .GE (greater than or equal) .EQ (equal), or .NE (not equal)), the addresses of the two variables being compared, a pointer to the statement to branch to if the expression is false, and a pointer to the parameter block of the function being used in the comparison. When the turboed version of this statement is executed, the IF turbo processing routine is called by the main interpreter loop.

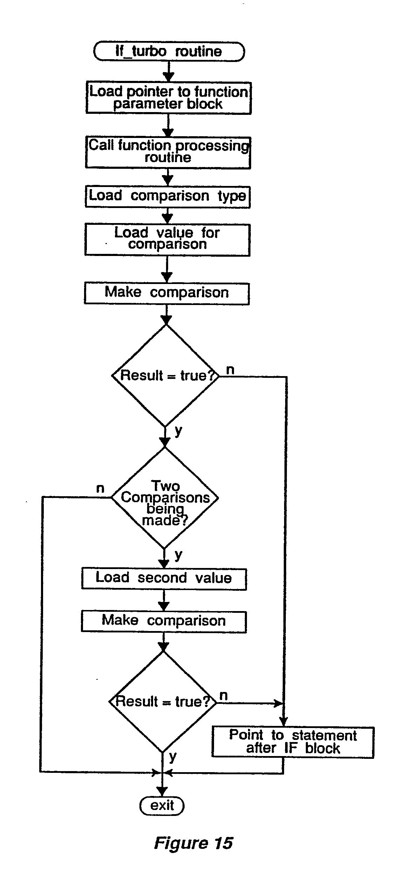

This routine executes as shown in Figure 15. First, the parameter block for the function being used is passed to the normal interpreter routine which handles functions. The result of the function is returned to the IF turbo processing routine, which loads the first value being compared and then makes the appropriate comparison. If the comparison is false, the statement pointer is set to point to the statement following the IF block. If the comparison is true, the routine checks to see if the function value is being compared with two values. If not, the routine exits. If so, the second value is loaded and the comparison is made. Once again, if the comparison is false, the statement pointer is updated. The IF turbo processing routine then returns control to the main interpreter loop and execution continues.

The turbo code in this case can avoid the overhead normally required by the interpreter to call the different routines involved in getting the values pointed to by the variables, as well as the overhead of these routines which make the arithmetic comparisons.

A similar concept is used for statements such as the PRINT verb. One option that can be specified for a print verb is the unit number. This unit number controls whether output should go to the screen, line printer, or other device. One possible value for the unit number is -1, which specifies that the print statement should be ignored. This is typically used to control the output of certain information within a device test program. At the beginning of the program, a physical sense switch on the test head is checked by the software.

If the switch is off, the unit number is set to -1. If the switch is on, the unit number will be set to some other meaningful value, usually 1 to select the CRT screen or 3 to select the line printer. This allows an engineer to turn the output on or off using the testhead sense switch without having to stop the program execution and edit the source code.

It is very desirable to have the PRINT verb determine as fast as possible when the unit number is -1 so that the rest of the processing for the PRINT statement can be skipped. This is accomplished by using a fairly simple turbo structure.

When a PRINT statement is executed and the unit number is determined to be -1, a table is built which contains the address of the variable used in the UNIT option. The parameter block pointer for the PRINT statement is also stored in the table. As with the other types of turbo, the parameter block pointer in the statement parm_rec is changed to point to this new table, and the verb address is changed to point to a new routine. The new routine in this case is the print turbo routine.

When a turboed PRINT statement is executed, the print turbo routine loads the address of the variable used in the .UNIT option and checks to see if the variable is still -1.

If so, the routine exits and execution continues with the next statement. If the variable is no longer -1, the original parameter block pointer for the statement is restored and the normal PRINT verb processing is called.

In general, well over half of the statements in a typical TPL device test program can be turboed by one of the methods described above. The execution times of these turboed statements are reduced considerably. For example, applying the method as described above to a PRINT instruction in which the unit is -1 decreases the average execution time for the statement from 129 microseconds to 7.5 microseconds. Similarly, the statement LET .VCC1 = 2.0V,100MA, that is shown above executes in 377 microseconds without turbo, but executes in 24 microseconds when turbo is enabled.

Overall, the majority of TPL programs run four to five times faster with turbo enabled than with turbo disabled. In addition, the total test time for all devices is significantly faster than the test times on a comparable tester which uses a compiled test language.

The invention described above relates to a method of modifying an interpreter in order to achieve greatly increased execution speed without sacrificing the advantages inherent in an interpreted environment. A specific embodiment has been shown in the drawings and description above. However, it should be understood that it is not intended to limit the invention to the particular examples shown. In fact, other modifications and applications will be apparent to those skilled in the art, and the invention is intended to cover all changes and modifications which are true to the spirit and scope of the invention.

**APPENDIX A**

TPL Statements and Functions that can be turboed

**TABLE 1**

TPL statements that can be turboed

1a. LET function = constant values
where one or more constant values are assigned to a single hardware function.
ex: LET .TPER = 100nS
LET .VCC1 = 1.5V,200mA

1b. LET function (array) = constant values
where one or more constant values are assigned to a hardware function on a list of pin boards.
ex: LET .VTH(IN:PINS) = 2.0V

1c. LET function(array(subscript)) = constant values
where one or more constant values are assigned to a hardware function on a single pin board selected from a list.
ex: LET .VTH(IN:PINS(I)) = 2.0V

2a. ENABLE board list
where a board or list of boards are being enabled.
ex: ENABLE .VCC1, .PMU(OUT:PINS)

2b. DISABLE board list
where a board or group of boards are being disabled.
ex: DISABLE .VCC1, .PMU(OUT:PINS)

3. TMU (parameters)
where all of the parameters refer to a constant pin number or to a single pin number selected from a list of pins.
ex: TMU .TIMRNG(3nS,.DLYENA(IN:PINS(I)))-,.STOP(OUT:PINS(I))

4. CONVERT .PMUV(array)
where a CONVERT ALL strobe is sent to a list of pin boards.
ex: CONVERT .PMUV(OUT:PINS)

5a. IF var <.LT/.GT/.GE/.LE/.EQ/.NE> function
where a single hardware function is being compared with a single variable or constant value.
ex: IF MIN .LT .ABS(VAR)

5b. IF var <.LT/.GT/.GE/.LE/.EQ/.NE> function (.LT ... NE> var
where a single hardware function is being compared with two single variables or constants, using the same type of comparison.
ex: IF MIN .LT .ABS(VAR) .LT MAX

6. PRINT .UNIT(n),expression
where n = __1.

7. LET reading = .ADC(exp)
where a reading is being taken from a single Analog to Digital converter.
ex: LET VAR = .ADC( .VCC1( .ICC1))

**TABLE 2**

TPL hardware functions that can be turboed using form a

.TPER: program system period generator
.VCC1: program voltage to VCC1 board
.VCC2: program voltage to VCC2 board
.ICC1: program current to ICC1 board
.ICC2: program current to VCC2 hoard

**TABLE 3**

TPL hardware functions that can be turboed using form 1b or 1c

(either a pin list or a specific pin selected from a pin list)

.CPEDG: set compare edge delay generator on pin PWB

.STEDG: set start edge delay generator on pin PWB

.SPEDG: set stop edge delay generator on pin PWB

.DRVL: set pin PWB 'low' programming driver reference level

.DRVH: set pin PWB 'high' programming driver reference level

.DRVP: set pin PWB PAL programming driver reference level

.RCVL: set pin PWB 'low' programming receiver reference level

.RCVH: set pin PWB 'high' programming receiver reference level

.IOL: set sourcing current for pin PWB

IOH: set sinking current for pin PWB

.VTH: set programmable load threshold on pin PWB

.PINFMT: set pin PWB format for drivers

.PMUV: program voltage for Parametric Measurement Units

.PMUI: program current for Parametric Measurement Units

.RLY: set relays on pin PWB or PMU

.HOTRLY: set relays on pin PWB when drivers, PMU, or PLOAD enabled

## Claims

1. A method of increasing the speed of test program execution of a test system having a processor controlled test head, and in which the test program executes a single test loop continuously to test a large number of semiconductor devices, including the steps of:
executing a main program loop, of interpreted code, of the test program;
constructing a table of constant values, at specified addresses, used by the program during the first execution of the main program loop; and
modifying the internal representation of the interpreted code on subsequent executions of the main program loop so that the only processing which occurs is to write the table of values to their corresponding specified addresses.

2. The method according to claim 1, including the step of storing the addresses of selected variables in a table to allow direct access to these variables during program execution.

3. The method according to claim 1, wherein the main program loop includes a series of program statements defined by parameter records, and each program statement includes a verb routine used to interpret the verb specified by the statement.

4. The method according to claim 3, wherein each parameter record for each statement contains a pointer to the verb routine specified by the statement.

5. The method according to claim 3, including the steps of;
executing the main program loop setting up several pointers, transfering execution to one or more verb processing routines,
incrementing the pointers after each verb execution; and
continuing the program until no more executable statements remain in the main program loop.

6. A method of increasing the speed of test program execution of a test system having a processor controlled test head, and in which the test program executes a single test loop continuously to test a large number of semiconductor devices, including the steps of:
executing a main program control routine, of interpreted code, of the test program;
modifying the internal representation of the interpreted code on subsequent executions of the main program loop so that the only processing which occurs is to write the table of values to their corresponding addresses.
constructing a table of constant values used by the program during the first execution of the main program loop;
the main program loop setting up several pointers, the main program loop including a series of program statements defined by parameter records, and each program statement includes a verb routine used to interpret the verb specified by the statement;
transfering execution to one or more verb processing routines,
incrementing the pointers after each verb execution; and
continuing the program until no more executable statements remain in the main program loop.

7. The method according to claim 6 wherein subsequent to the main program control routine the method includes the steps of:
loading a parameter block pointer;
loading the address of a verb routine;
transfering execution to the verb routine;
testing for errors;
incrementing pointers;
testing for end of program; and
looping to the step of loading a new parameter block pointer if not end of program.

8. A method of increasing the speed of test program execution of a test system including a processor and having a processor controlled test head, and in which the test program executes a single test loop continuously to test a large number of semiconductor devices, including the steps of:
memory mapping the test head hardware into the address space of the test system processor;

executing a main program loop, of interpreted code, of the test program;

executing instructions in the main program loop;

constructing a table of constant values, at specified addresses, used by the program during the first execution of the main program loop; and

modifying the internal representation of the interpreted code on subsequent execution of the main program loop so that the only processing which occurs is to write the table of values to their corresponding specified addresses.

9. The method according to claim 8, wherein each instruction starts with a verb and is followed by specific variable names and parameters as allowed by the syntax of each verb.

10. The method according to claim 9, wherein as each statement is loaded into memory for execution, it is translated into a parameter record which includes a pointer to the source code for each statement, pointers to the next statement, various flags and variables and a pointer to the parameter blocks of the statement.

11. A test system for executing interpreted language programs at speeds comparable to and faster than a complied language program, comprising;

a central controller/computer;

one or more device test heads controlled by said central controller;

a memory array into which the test head hardware is memory mapped into the address space of the central processor;

a bus controller;

and a test head monitor for each test head.

12. the test system according to claim 11, wherein said bus controller is a VMEbus controller.

13. The system according to claim 11, wherein there is a central controller for each test head.

14. A method of increasing the speed of test program execution of a test system having a processor controlled test head and in which the test program executes a single test loop continuously to test a large number of semiconductor devices, including the steps of:

changing each program into a pseudo code;

using the first execution of each program statement of the test program in an interpreted environment to build a table of values computed or used by the statement; and

changing the pseudo code of each statement to execute a new routine which uses the computed values.

15. The method according to claim 14, wherein the table created on the first execution of the program statement contains a set of address-value pairs corresponding to the values computed by the statement, and the routine used on subsequent executions writes each value of said table to its appropriate address.

16. The method according to claim 14, wherein the table of values created on the first execution of the statement contains the addresses of the values computed by the routine.

17. The method according to claim 15, wherein the table of values contains a set of address-value pairs corresponding to all possible values of an array, each address-value pair having a subscript dependent upon its position in the array, and the set of address-value pair selected depending upon its array subscript.

18. A method of increasing the speed of test program execution of a test system having a processor controlled test head and in which the test program executes a single test loop continuously to test a large number of semiconductor devices, including the steps of:

changing each program statement into a pseudo code;

using the first execution of each program statement of the test program in an interpreted environment to build a table of address-value pairs corresponding to values computed by the statement; and

changing the pseudo code of each statement to use a short assembly language routine to write each value in said table to its appropriate address.

19. The method according to claim 18, wherein said test head hardware is memory mapped and the memory map feature is used to write each value in said table to its appropriate address.

20. The method according to claim 18, wherein the pseudo code structure of each program statement is structured to allow the pseudo code to be altered at runtime to change the flow of execution.

21. The method according to claim 18, wherein a plurality of the program statements compute values which do not change from one execution of the statement to the next and compute variables which depend only on the selection of an array element where all possible values of the array can be determined the first time the statement is executed.

22. The method according to claim 18, executing the program loop once for each value that needs to be written by the routine.

23. The method according to claim 18, including the step of error checking and calibration the first time a code statement is executed.

24. The method according to claim 18, wherein only three instructions are executed per value computed plus a fixed number of overhead statements.

11 — Edit source code

12 — Compile

Compilation Successful? — n

y

13 — Link

Link Successful? — n

y

14 — Load

15 — Execute

**a. Compiled language**

16 — Edit source code/ translate

17 — Execute

**b. Interpreted language**

*Figure 1*

*Figure 2*

## Figure 3

```
                    ┌─────────────────────────┐
                    │     BUS  CONTROLLER      │
                    └─────────────────────────┘
                          VME BUS
                       (P1 BACKPLANE)
┌──────────────┐    ┌─────────────────────────┐    ┌──────────────┐
│  SYSTEM CRT  │◄──►│    SYSTEM PROCESSOR      │◄──►│     SIC      │
└──────────────┘    └─────────────────────────┘    └──────────────┘
                    ┌─────────────────────────┐    ┌──────────────┐
                    │    NETWORK  PROCESSOR    │◄──►│     LAN      │
                    └─────────────────────────┘    └──────────────┘
                    ┌─────────────────────────┐
                    │  NONVOLATILE STATIC RAM  │
                    └─────────────────────────┘
                    ┌─────────────────────────┐    ┌──────────────┐
                    │        SERIAL I/O        │◄──►│  4 CONFIG.   │
                    └─────────────────────────┘    │ RS232 PORTS  │
┌──────────────┐    ┌─────────────────────────┐    └──────────────┘
│ FLOPPY and   │◄──►│     DISK  CONTROLLER     │
│ WINCHESTER   │    └─────────────────────────┘
└──────────────┘    ┌─────────────────────────┐    ┌──────────────┐
                    │     GPIB  CONTROLLER     │◄──►│     GPIB     │
                    └─────────────────────────┘    └──────────────┘
┌──────────────┐    ┌─────────────────────────┐    ┌──────────────┐
│  T.H. 1 CRT  │◄──►│ TEST HEAD PROCESSOR #1   │◄──►│  TEST HEAD   │
└──────────────┘    └─────────────────────────┘    │     #1       │
┌──────────────┐    ┌─────────────────────────┐    └──────────────┘
│  T.H. 2 CRT  │◄──►│ TEST HEAD PROCESSOR #2   │◄──►│  TEST HEAD   │
└──────────────┘    └─────────────────────────┘    │     #2       │
                    ┌─────────────────────────┐    └──────────────┘
                    │  HANDLER INTERFACE #1    │◄──►│  HANDLER #1  │
                    └─────────────────────────┘    └──────────────┘
                    ┌─────────────────────────┐    ┌──────────────┐
                    │  HANDLER INTERFACE #2    │◄──►│  HANDLER #2  │
                    └─────────────────────────┘    └──────────────┘
                    ┌─────────────────────────┐    ┌──────────────┐
                    │       PARALLEL I/O       │◄──►│    POWER     │
                    └─────────────────────────┘    │   SUPPLY     │
                    ┌─────────────────────────┐    └──────────────┘
                    │       DYNAMIC RAM        │
                    └─────────────────────────┘
```

*Figure 3*

## Figure 4

35 parm_rec

| | |
|---|---|
| 48 | verb address |
| 40 | stnum |
| | errflg |
| 39 | nextemu |
| 37 | nextseq |
| 38 | lastseq |
| 41 | parm block |
| 36 | source |

parametric blocks

42 — verb parm / LET

43 — hdw parm / .VCC1

44 — asg parm
*assignment*

45 — sdf parm / 2.0 V

46 — ft parm
*field terminator*

47 — sdf parm / 100MA
*self defining float*

LET .VCC1 = 2.0V, 100MA

*Figure 4*

50 — ( Main control routine )

51 — Load parameter block Pointer

52 — Load address of verb routine

53 — Jump to verb routine

error? — y → Call error handler

n

54 — increment pointers

done? — n

y

( exit )

**Figure 5**

60 — ( VCC Processing )

61 — Get voltage value

62 — more values? — n

y

63 — Get current value

64 — Call set_icc

65 — Call set_vcc

( exit )

**Figure 6**

Figure 7

VCC Processing

71 — Get voltage value

72 — more values? — n

y

73 — Get current value

74 — Call set_icc

75 — Store current values in Turbo table

Call set_vcc

76 — Store voltage values in Turbo table

77 — Modify parm blocks

exit

*Figure 8*

Parm_rec

| verb address |
| stnum |
| errflg |
| nextemu |
| nextseq |
| lastseq |
| parm block |
| source |

parametric blocks

| verb parm |
| LET |

| Turbo parm | |
| Number entries | |
| Address | Value |
| Address | Value |
| " | " |
| " | " |

LET .VCC1 = 2.0V, 100MA

**Figure 9**

Turbo routine

80 — Load number of entries

81 — Load address

82 — Load value and write to address

83 — Decrement counter

84 — Counter = 0?

n

y

exit

**Figure 10**

| Addess of index |
| Maximum index |
| Entry size |
| Data pointer |
| Index # 1 |
| Index # 2 |
| " |
| " |

| Address | Value |
|---------|-------|
| Address | Value |
| " | " |
| Address | Value |
| Address | Value |
| " | " |
| " | " |

**Figure 11**

**Figure 12**

Where a pt_function is begin compared withs either constants or simple variables, the
Mathematical Relational Operators : .LT, .GT, .LE, .GE, .EQ, or .NE may be used.

Example of pt_function(expression) :

IF min .LT .ADC(.VCC1(.ICC1)) .LT max

## *Figure 13*

| Single comparison flag |
|---|
| Comparison type |
| Value 1 |
| Value 2 |
| False branch address |
| Function pointer |

## *Figure 14*

Figure 15